# EUROPEAN PATENT APPLICATION

(11) **EP 1 355 521 A2**
(43) Date of publication of application: **22.10.2003**
(21) Application number: 03007889.3
(22) Date of filing: 07.04.2003
(51) Int. Cl.: H05K 3/22, H05K 3/34

(54) **Printed circuit board and restoration thereof**

(30) Priority: 16.04.2002 JP 2002112900; 13.03.2003 JP 2003068114
(71) Applicant: CANON KABUSHIKI KAISHA, Ohta-ku, Tokyo (JP)
(72) Inventor: Ikeda, Yukihito, c/o Canon Kabushiki Kaisha, Tokyo (JP); Nagahira, Joji, c/o Canon Kabushiki Kaisha, Tokyo (JP)
(74) Representative: Weser, Wolfgang, Dr. Dipl.-Phys.

(57) **Abstract**

A printed circuit board (1) comprises plural electronic parts (3, 4, and 5), a printed-wiring board (2) for mounting the plural electronic parts mounted thereon, and soldered portions provided on the printed-wiring board, wherein the soldered portion connects electrically the printed-wiring board and the electronic part by solders (3b, 4b, and 5b), and a soldered portion to be restored is assigned according to a failure data derived in a preliminary reliability test of a printed circuit board, and the assigned soldered portion is subjected to re-soldering. A method for restoring a printed circuit board (1) comprises steps: recovering a printed circuit board used in market having plural electronic parts (3, 4, and 5) mounted through solders (3b, 4b, and 5b) at soldered portions provided on a printed-wiring board (2), assigning soldered portions to be restored according to a failure data derived in a preliminary reliability test of a same printed circuit board, and carrying out a re-soldering at the assigned soldered portion.

## Description

### BACKGROUND OF THE INVENTION

### Field of the Invention

The present invention relates to recycle of printed circuit boards of electronic apparatuses, in particular to a method of restoring a printed circuit board.

### Related Background Art

In recent years, in manufacture of electronic apparatuses such as copying machines and printers, collection and recycle of used apparatuses is an important problem to be developed for environmental preservation. Japanese Patent Application Laid-Open No. 10-34122 discloses an invention on recycle of image-forming apparatuses such as copying machines and printers. This Laid-Open publication describes estimation of a remaining service life of a recovered part from the quality information on troubles and part-exchange of the used apparatus and from the technical information obtained by examination of the detached part. Thereby the part is reused which has an estimated remaining service life longer than the quality-guarantee period of the manufactured apparatus, whereas the part which has an estimated remaining service life shorter than the quality-guarantee period is replaced by a new part.

One example of the parts to be recycled is a printed circuit board. As the results of examination of actually recovered printed circuit boards, the failures of printed circuit board are often caused by a defect in a soldered portion rather than failure of the electronic part mounted thereon. The defect in the soldered portion can be cause by thermal stress produced therein by the heat generated by the electric parts mounted on the printed circuit board, and temperature variation in the environment. The repeated action of the thermal stress against the printed circuit board will form a crack by fatigue to cause an electric failure.

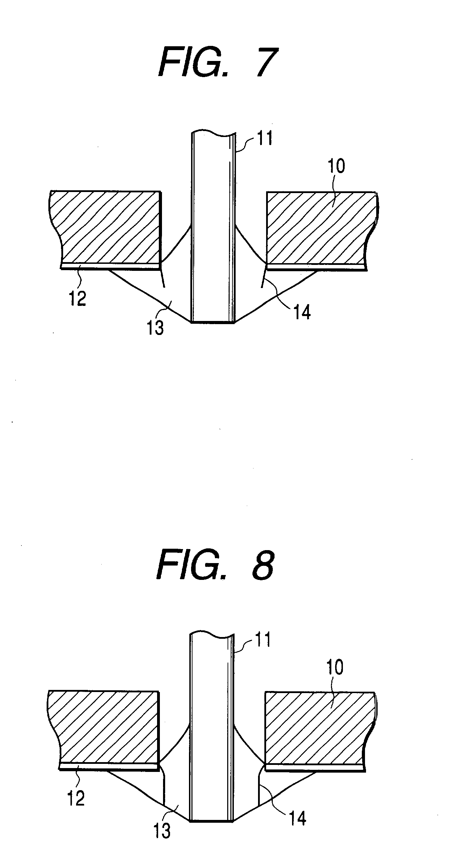

Fig. 7 is a sectional view illustrating a soldered portion of a printed circuit board, showing a state of connection of lead 11 of an electronic part (not shown in the drawing) with wiring pattern 12 on the lower face of printed-wiring board 10 by soldering. In Fig. 7, cracks 14 formed are shown in the portion of solder 13 owing to the fatigue caused by the aforementioned thermal stress. Crack 14 will spread gradually with lapse of time, finally breaking the connection between the lead 11 of the electronic part and wiring pattern 12 to cause electric disconnection and destroy the electric function of the printed circuit board as shown in Fig. 8.

For this reason, conventionally, all of the soldered portions of the recovered printed circuit boards are inspected visually and electrically. In the inspection, the soldered portion is examined for absence of a crack or a defect of the solder visually and for electrical connection to judge whether the soldered portion satisfies the prescribed quality standard. The portion that does not satisfy the quality standard is restored by re-soldering. For the safety, sometimes, all the recovered printed circuit boards are subjected to re-soldering for the reuse.

However, the aforementioned conventional methods of the restoration of printed circuit boards have problems shown below.

In the inspection of the recovered printed circuit boards, the detection is limited to visually apparent crack or falling-off of the solder, and to electric disconnection. It is difficult to detect and repair the crack inside the soldered portion. Naturally, it is impossible to detect a soldered portion, which may cause cracking or other defect in near future. Such a not-rejected defective printed circuit board can cause disconnection soon in recycled use, and can frequently lose the electric circuit function of the printed circuit board. Such a defective printed circuit board will fail soon during service as the recycled article in the market. This is a serious problem.

With the development of a high-density mounting technique, the number of the electronic parts mounted on the printed circuit board is increasing. Therefore, the aforementioned prior art techniques, which inspect all of the soldered portions, require a lot of time and labor for inspection of the increased inspection points, and may cause inspection miss in a higher possibility. Moreover, re-soldering of all of the soldered portions of the recovered printed circuit boards requires greater time and much more labor, being not applicable industrially.

### SUMMARY OF THE INVENTION

The present invention has been made to solve the above problems.

According to an aspect of the present invention, there is provided a printed circuit board comprising plural electronic parts, a printed-wiring board for mounting the plural electronic parts mounted thereon, and soldered portions provided on the printed-wiring board, wherein the soldered portion connects electrically the printed-wiring board and the electronic part by solder, and the soldered portion to be restored is assigned according to a failure data derived in a preliminary reliability test of a printed circuit board, and the assigned soldered portion is subjected to re-soldering. The soldered portion to be restored may have a remaining service life shorter than a prescribed necessary period for the printed circuit board. The reliability test may be a thermal fatigue test.

According to another aspect of the present invention, there is provided a method for restoring a printed circuit board comprising steps: recovering a printed circuit board used in market having plural electronic parts mounted through solder at soldered portions provided on a printed-wiring board, assigning soldered portions to be restored according to a failure data derived in a preliminary reliability test of a same printed circuit board, and carrying out a re-soldering at the assigned soldered portion. The soldered portion to be subjected to re-soldering may have a remaining service life shorter than a prescribed period necessary for the printed circuit board. The reliability test may be a thermal fatigue test.

According to still another aspect of the present invention, there is provided a method for restoring a printed circuit board having plural electronic parts mounted through solder at soldered portions, which has been installed in an electronic apparatus, comprising steps: collecting and analyzing a failure data by conducting preliminarily a reliability test of a fresh printed circuit board, recovering the electronic apparatus from market, disassembling the recovered electronic apparatus and classifying the parts thereof, collecting the printed circuit board installed in the electronic apparatus, assigning a soldered portion to be restored of the recovered printed circuit board according to the failure data, carrying out a re-soldering at the assigned soldered portion, inspecting the printed circuit board, and recycling the restored printed circuit board. A defective electronic part found in the inspecting step may be replaced with a non-defective electronic part.

The above and other objects of the invention will become more apparent from the accompanying drawings. In the figures, like reference characters indicate like parts or meanings.

### BRIEF DESCRIPTION OF THE DRAWINGS

Fig. 1 is a perspective view of a printed circuit board of a first embodiment of the present invention.
Fig. 2 is a sectional view of a soldered portion for mounting a chip resistance on a printed-wiring board.
Fig. 3 is a sectional view of a soldered portion for mounting a connector on a printed-wiring board.
Fig. 4 is a perspective view illustrating a state of crack generation in a solder at a soldered portion for mounting a chip resistance on a printed-wiring board.
Fig. 5 is a perspective view illustrating a state of crack generation in a solder at a soldered portion for mounting the connector on a printed-wiring board.
Fig. 6 is a flow chart showing the steps for recycling the printed circuit board according to the first embodiment of the present invention.
Fig. 7 is a sectional view illustrating a state of crack generation inside a solder at a soldered portion of a printed circuit board.
Fig. 8 is a sectional view illustrating another state of crack generation inside a solder at a soldered portion of a printed circuit board.

### DESCRIPTION OF THE PREFERRED EMBODIMENTS

The embodiments of the present invention are described below in detail by reference to drawings.

### (First Embodiment)

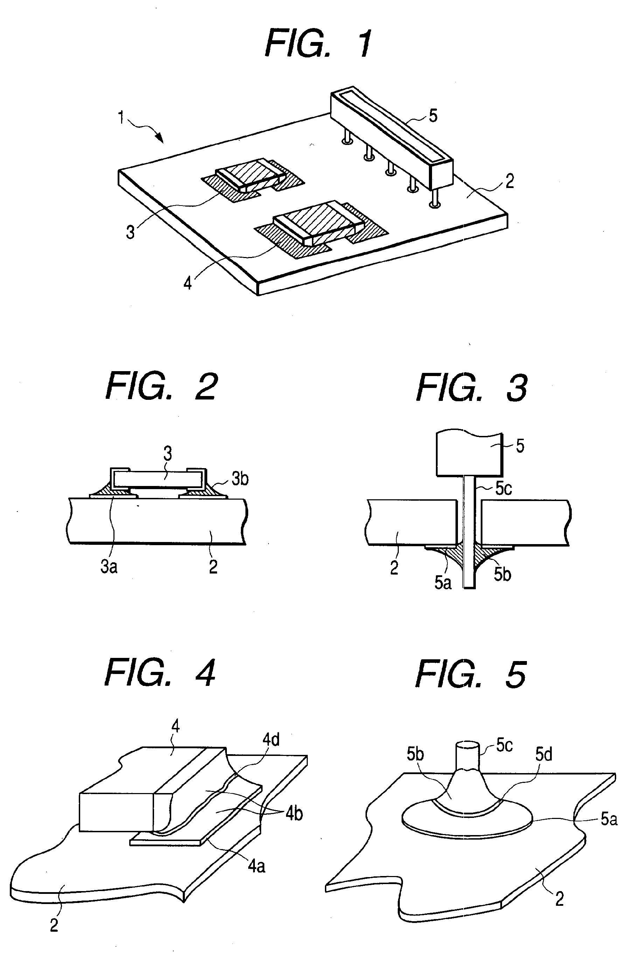

Fig. 1 is a perspective view of a printed circuit board for an electronic apparatus employed in the restoration method of the present invention. In Fig. 1, the reference numerals denote the members as follows: 1, a printed circuit board; 2, a printed-wiring board made of glass, an epoxy resin, or the like; 3 and 4, respectively a chip resistance mounted on printed-wiring board 2, chip resistance 4 being larger in size than chip resistance 3; and 5, a lead-insertion type connector mounted on printed-wiring board 2.

Fig. 2 is a sectional view illustrating a soldered portion for mounting chip resistance 3 on printed-wiring board 2. Chip resistance 3 is surface-mounted on printed-wiring board 2. The numeral 3a denotes a wiring pattern formed on printed-wiring board 2. The numeral 3b denotes solder. Chip resistance 3 is fixed and connected electrically by solder 3b to wiring pattern 3a on printed-wiring board 2. Chip resistance 4 is mounted onto printed-wiring board 2 in the same manner.

Fig. 3 is a sectional view illustrating a soldered portion for mounting connector 5 on printed-wiring board 2. Connector 5 is mounted on printed-wiring board 2 by inserting lead 5c into through-holes formed on printed-wiring board 2. The numeral 5a denotes a wiring pattern formed on printed-wiring board 2. The numeral 5b denotes solder. Connector 5 is fixed and connected electrically by solder 5b to wiring pattern 5a on printed-wiring board 2.

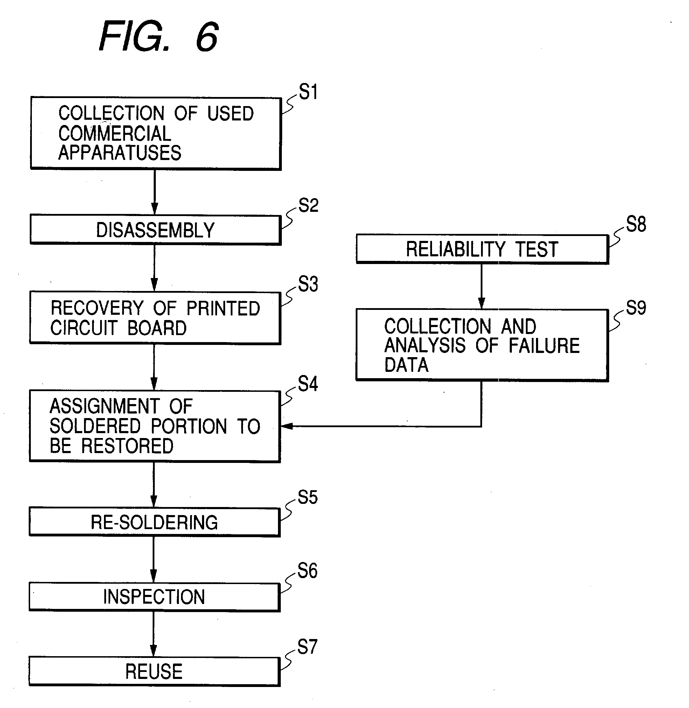

Fig. 6 is a flow chart showing the steps of recycling the printed circuit board. Firstly, a great number of electronic apparatuses that were used in the market are collected (S1). The collected apparatuses include various states of apparatuses such as those after expiration of guarantee periods, those within the guarantee period, those having a failure, and those being non-defective.

The collected commercial apparatuses are disassembled into constituent elements (S2): for example, a copying machine is disassembled into a photosensitive drum, a development sleeve, a scanner, a transfer roller, an electrifying roller, an outer molded parts, and so forth.

The parts obtained by the disassembling step S2 are classified. In the classification, printed circuit boards are recovered as one of the constituent elements (S3). When plural kinds of printed circuit boards are included, they are classified into the respective kinds. In the recovery, electronic parts are not separated and are kept on the printed circuit boards.

Separately, a fresh printed circuit board of the same kind as the recovered printed circuit board is subjected to reliability test preliminarily (S8). The reliability is generally confirmed by a thermal fatigue test. The test conditions of the thermal fatigue test are selected from the conditions corresponding to thermal stress caused in the printed circuit board by circumference temperature in practical uses of the electronic apparatuses. The thermal fatigue test is preferably conducted effectively under accelerated fatigue test conditions in comparison with the practical use conditions for obtaining the test results in a shorter time. The accelerated thermal fatigue test of the soldered portion corresponds well with practical fatigue state owing to less uncertainty in comparison with electronic parts and other parts.

The results of the thermal fatigue tests in S8 are collected and analyzed as failure data (S9). Thereby, the possible service duration before occurrence of failure such as disconnection can be estimated for the respective soldered portions of a printed circuit board. Thus the soldered portion to be restored can be assigned for guarantee for a prescribed period in the reuse, based on the information on the history of recovered printed circuit board.

Next, the soldered portion to be restored of the printed circuit board recovered in S3 is assigned from the past service period and other information based on the data collected and analyzed in S9 (S4).

All of the assigned soldered portions are soldered again (S5). The soldering may be conducted by re-fusing the existing solder on the solder portion of the printed circuit board, or may be conducted newly after removing the existing solder.

The restored printed circuit board is subjected to appearance examination and electrical test (S6). If the soldered portion assigned in S4 and restored is rejected by the inspection, the soldering of S5 is conducted again. If the re-soldered portion in S5 is rejected again by the inspection, the failure is considered to be due to a cause other than the soldering and another measure is taken such as exchange of the mounted electronic part. On the other hand, if the portion other than the soldered portion restored in S4 is still defective, the mounted electric part is exchanged.

The printed circuit board acceptable in the inspection in step S6 is installed in an electronic apparatus and is shipped for reuse to the market (S7).

The failure of the printed circuit board can be caused not only by the soldered portion but can possibly be caused by failure or insufficient life of the mounted electronic parts. Therefore, two methods are possible naturally for the recycle: restoration of the soldered portion as in the above embodiment; and exchange of the part as described in Japanese Patent Application Laid-Open No. 10-34122. Incidentally, failure of the printed circuit board is caused by a defect of the soldered portion at a much higher probability. Therefore, for the recycle, the restoration of the soldered portion is tried preferably firstly, and the part is exchanged secondly. In such a manner, the recycle can be conducted efficiently by restoring collected printed circuit boards by a reduced time and reduced labor for putting the recycled printed circuit boards.

Specific example is shown below for the embodiment of the present invention.

### (Example 1)

In this Example, printed circuit board 1 shown in Fig. 1 was restored for recycle. Firstly, an electronic apparatus having printed circuit board 1 was brought back from the market (S1). Then the electronic apparatus was disassembled (S2). The parts obtained by the disassembly were classified to recover printed circuit board 1 (S3).

Here, the reliability test in S8 and the collection and analysis of failure data in S9 are explained which are conducted preliminarily with fresh printed circuit board 1. In this Example, a thermal fatigue test was conducted as the reliability test. In the thermal fatigue test, a tested object (printed circuit board 1) is placed in a chamber in which the environmental temperature can be changed, and thermal stress is applied to the tested object by changing the temperature cyclically. By this thermal fatigue test, the test result can be obtained in a shorter time in comparison with the practical environmental temperature change of the printed circuit board installed in an electronic apparatus in the market. In particular, the thermal fatigue test of the soldered portion of the printed circuit board gives precise result consistent with that in the practical use.

In the test, specifically, printed circuit board 1 was placed in a chamber capable of changing the internal environmental temperature, and the tested board was exposed at environmental temperatures changes between 125°C and -25°C cyclically. In every cycle, the absence or presence of a crack was examined in the soldered portions of chip resistances 3 and 4 and connector 5 for mounting on printed circuit board. Table 1 shows the results.

**Table 1**

| Number of cycles | 50 cycles | 100 cycles | 150 cycles | 200 cycles |
|---|---|---|---|---|
| Chip resistance 3 | ○ | ○ | ○ | ○ |
| Chip resistance 4 | ○ | ○ | ○ | × |
| Connector 5 | ○ | ○ | × | × |
| ○: No crack, ×: Crack formed | | | | |

Table 1 shows that the solder portion of chip resistance 4 came to crack before 200 cycles, and the solder portion of connector 5 came to crack before 150 cycles. From such collection and analysis of the reliability test data and the failure data, it is estimated that chip resistance 3 will endure 200 cycles or more, chip resistance 4 will endure 150 cycles, and connector 5 will endure 100 cycles.

Fig. 4 is a schematic view showing a state of a formed crack at the soldered portion of chip resistance 4. In Fig. 4, the numeral 4a denotes a wiring pattern formed on printed-wiring board 2, and the numeral 4b denotes solder. Chip resistance 4 is fixed and electrically connected by solder 4b to wiring pattern 4a on printed-wiring board 2. The numeral 4d denotes a crack formed in solder 4b. Crack 4d has broken the electric connection between the chip resistance 4 and wiring pattern 4a, or will break the connection in near future.

Fig. 5 is a schematic view showing a state of a formed crack at the soldered portion of connector 5. In Fig. 5, the same reference numerals are used as in Fig. 3 without explanation. The numeral 5d denotes an annular crack formed in solder 4b. Crack 5d has broken the electric connection between connector 5 and wiring pattern 5a, or will break the connection in near future.

Next, the position to be restored of printed circuit board 1 recovered in S3 is assigned (S4). The specified period (guarantee period) required for printed circuit board 1 of the recycled article corresponds to 100 cycles of the above thermal fatigue test. Here, it is assumed that the past service period of recovered printed circuit board 1 corresponds to 50 cycles of the aforementioned thermal fatigue test. Generally, the use history of a recovered printed circuit board is recognizable from an IC tag or counter in the main body. With the above assumption, chip resistance 3 and chip resistance 4 are estimated to be serviceable without formation of a crack for a future service period corresponding to 100 cycles in consideration of the failure data of S9. However, connector 5 can fail by solder crack formation during a future service period corresponding to 100 cycles with a high probability. Therefore, the soldered portion for connector 5 is assigned as the position to be restored.

If the use history of recovered printed circuit board 1 corresponds to 80 cycles of the aforementioned thermal fatigue test, chip resistance 3 is estimated to be serviceable for a future service period corresponding to 100 cycles without formation of a crack in consideration of the failure data of S9. However, chip resistance 4 and connector 5 can fail by solder crack formation during use period corresponding to 100 cycles with a high probability. Therefore, the soldered portions for chip resistance 4 and connector 5 are assigned as the positions to be restored.

In the next step, the soldered portion assigned in S4 was restored by re-soldering (S5). In this example, the solder was retained without falling-off. Therefore, the existing solder was restored by re-fusing. In the case where most part of the solder is kept remaining, the soldering for restoration may be conducted by re-fusing or by new soldering without significant reliability difference.

The printed circuit board after the restoration by soldering in S5 was inspected for external appearance and electric properties (S6). The external appearance is examined visually. The electrical test of the soldered portion was made by conduction test. In the case where the soldered portion assigned in S4 and restored in S5 is rejected by the inspection, the soldered portion is again soldered for restoration as in S5. If the re-soldered portion is rejected again by the inspection, the failure is considered to be due to a cause other than the soldered portion and another measure is taken such as exchange of the mounted electronic part.

The printed circuit board acceptable in the inspection in S6 is installed in an electronic apparatus and is shipped for reuse to the market (S7).

The method of restoration of a printed circuit board of the present invention, as described above, provides a printed circuit board serviceable at least a prescribed period (guarantee period) without failure by estimating preliminarily possible failure of soldered portion.

Furthermore, the method of the present invention enables reducing the time and labor for recycle of recovered printed circuit boards for reuse as a commercial product, thereby realizing highly efficient restoration of a printed circuit board.

## Claims

1. A printed circuit board (1) having plural electronic parts (3, 4, and 5) mounted through solders (3b, 4b, and 5b) on soldered portions, which is **characterized in that** a soldered portion to be restored is assigned according to a failure data derived in a preliminary reliability test of a fresh printed circuit board, and the assigned soldered portion is subjected to re-soldering.

2. The printed circuit board according to claim 1, wherein the soldered portion to be restored has a remaining service life shorter than a prescribed necessary period for the printed circuit board.

3. The printed circuit board according to claim 1 or 2, wherein the reliability test is a thermal fatigue test.

4. A method for restoring a printed circuit board (1) having plural electronic parts (3, 4, and 5) mounted through solders (3b, 4b, and 5b) on soldered portions comprising steps:
recovering a printed circuit board used in market having plural electronic parts mounted through solder at soldered portions provided on a printed-wiring board,
assigning soldered portions to be restored according to a failure data derived in a preliminary reliability test of a same printed circuit board, and
carrying out a re-soldering at the assigned soldered portion.

5. The method for restoring a printed circuit board according to claim 4, wherein the soldered portion to be subjected to re-soldering has a remaining service life shorter than a prescribed period necessary for the printed circuit board.

6. The method for restoring a printed circuit board according to claim 4 or 5, wherein the reliability test is a thermal fatigue test.

7. A method for restoring a printed circuit board (1) having plural electronic parts (3, 4, and 5) mounted through solders (3b, 4b, and 5b) at soldered portions, which has been installed in an electronic apparatus, comprising steps:
collecting and analyzing a failure data by conducting preliminarily a reliability test of a printed circuit board (1),
recovering the electronic apparatus from market,
disassembling the recovered electronic apparatus and classifying the parts thereof,
collecting a printed circuit board installed in the electronic apparatus,
assigning a soldered portion to be restored of the recovered printed circuit board according to the failure data,
carrying out a re-soldering at the assigned soldered portion,
inspecting the printed circuit board, and
recycling the restored printed circuit board.

8. The method of restoring a printed circuit board according to claim 7, wherein a defective electronic part found in the inspecting step is replaced with a non-defective electronic part.
